# EUROPEAN PATENT APPLICATION

(11) **EP 4 199 013 A1**
(43) Date of publication of application: **21.06.2023**
(21) Application number: 22213196.3
(22) Date of filing: 13.12.2022
(51) Int. Cl.: H01F 27/28, H01F 41/04, H01L 23/522, H01F 17/00

(54) **SEMICONDUCTOR PACKAGE, SEMICONDUCTOR DIE AND METHOD FOR FORMING A SEMICONDUCTOR PACKAGE OR A SEMICONDUCTOR DIE**

(30) Priority: 17.12.2021 US 202117644803
(71) Applicant: INTEL Corporation, Santa Clara, CA 95054 (US)
(72) Inventor: MOLZER, Wolfgang, 85521 Ottobrunn (DE); GOSSNER, Harald, 85521 Riemerling (DE); SEIDEMANN, Georg, 84036 Landshut (DE); WAIDHAS, Bernd, 93186 Pettendorf (DE); LANGENBUCH, Michael, 81825 München (DE)
(74) Representative: 2SPL Patentanwälte PartG mbB

(57) **Abstract**

A semiconductor package comprises a semiconductor die and a wiring structure, which is electrically connected to the semiconductor die. Further, the semiconductor package comprises a magnetic material. The magnetic material embeds and/or encircles a portion of the wiring structure.

## Description

### Background

Input/Output IO connections of chips may require the suppression of high-frequency interference (e.g. a combination of common mode filters with electrostatic discharge ESD protection). Examples may be damping of high frequency contributions, damping of sharp and/or fast transients and/or protecting high-speed differential-IOs.

### Brief description of the Figures

Some examples of apparatuses and/or methods will be described in the following by way of example only, and with reference to the accompanying figures, in which
Fig. 1 shows a schematic cross section of a semiconductor package;
Fig. 2 shows a schematic cross section of another semiconductor package;
Fig. 3a shows a schematic cross section of a semiconductor package during manufacturing;
Fig. 3b shows a schematic top view of the semiconductor package of Fig. 3a during manufacturing;
Fig. 4a shows a schematic cross section of another semiconductor package during manufacturing;
Fig. 4b shows a schematic top view of the semiconductor package of Fig. 4a during manufacturing;
Fig. 5a-5d shows schematic cross sections of a semiconductor package during manufacturing;
Fig. 5e shows a schematic cross section of a semiconductor package;
Fig. 6a-6d shows schematic cross sections of another semiconductor package during manufacturing;
Fig. 7a shows a schematic cross section of a current sending structure;
Fig. 7b shows a schematic top view of the current sending structure of Fig. 7a;
Fig. 8a shows a schematic cross section of a common mode choke structure;
Fig. 8b shows a schematic top view of the common mode choke structure of Fig. 8a;
Fig. 9a shows a schematic cross section of a common mode choke structure embedded in dielectric material;
Fig. 9b shows a schematic top view of the common mode choke structure of Fig. 9a;
Fig. 9c-9f show schematic cross sections and top views of embedded and/or encircled plated vias;
Fig. 10 shows a schematic illustration of an electrostatic discharge protection circuit;
Fig. 11 shows a schematic cross section of a semiconductor die;
Fig. 12 shows a flow chart of a method of forming a semiconductor package;
Fig. 13 shows a flow chart of a method of forming a semiconductor die; and
Fig. 14 shows a block diagram of an electronic device.

### Detailed Description

Some examples are now described in more detail with reference to the enclosed figures. However, other possible examples are not limited to the features of these examples described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

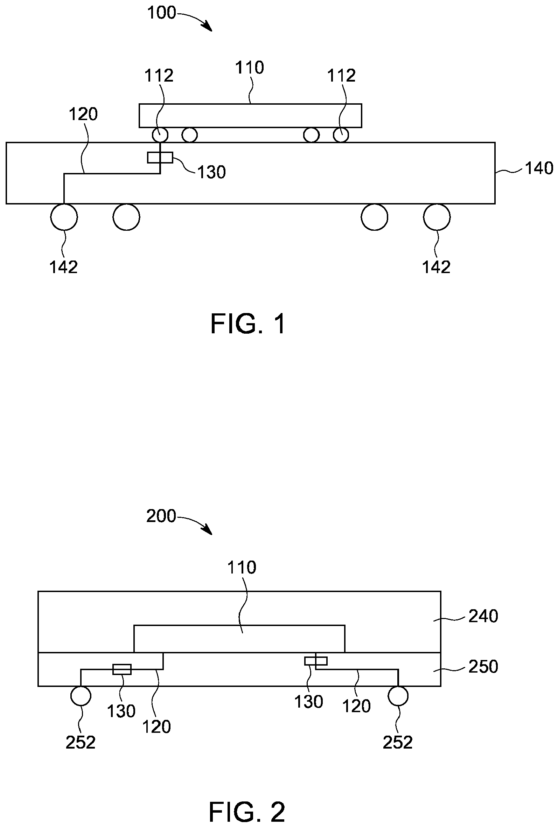

Fig. 1 shows a schematic cross section of a semiconductor package. The semiconductor package 100 comprises a semiconductor die 110 and a (first) wiring structure 120, which is electrically connected to the semiconductor die 110. Further, the semiconductor package 100 comprises a magnetic material 130. The magnetic material 130 embeds and/or encircles a portion of the wiring structure 120.

By embedding or encircling portions of wiring structures by magnetic material, a strong inductive coupling can be obtained. Due to the strong inductive coupling, high frequency portions of electrical signals on the wiring structures may be efficiently filtered. For example, high-frequency interference may be efficiently suppressed or reduced. For example, the ESD protection of the semiconductor die may be improved.

The magnetic material 130 may be at least partially embedded in a package structure. The package structure may comprise or may be a package substrate 140 (as shown in Fig. 1) or one or more redistribution layers RDLs (as shown in Fig. 2). The package substrate 140 may comprise a package substrate core or may be a coreless package substrate. The package substrate 140 may be a multi-layer package substrate.

For example, the (first) wiring structure comprises at least one of an embedded portion, which is embedded in the magnetic material 130, or an encircled portion which is encircled by the magnetic material 130. The portion of the wiring structure 120, which is at least one of embedded or encircled by the magnetic material 130, may also be called embedded and/or encircled portion. The magnetic material 130 may be in contact with the portion of the wiring structure 120 so that the portion of the wiring structure is embedded by the magnetic material at the contact region. The magnetic material 130 may be in contact with the portion of the wiring structure 120 along a complete circumference of the portion of the wiring structure 120 so that the magnetic material 130 embeds and encircles the portion of the wiring structure 120 at the same time or the magnetic material 130 may be in contact with the portion of the wiring structure 120 along only a part of a circumference of the portion of the wiring structure 120 so that the magnetic material 130 embeds the portion of the wiring structure 120, but does not encircle the portion of the wiring structure 120. Alternatively, the magnetic material 130 might not be in contact with the wiring structure, but it may encircle the portion of the wiring structure 120.

For example, the magnetic material 130 may have a permeability µ of more than 5 (or more than 10) and/or less than 15 (or less than 50) and/or a magnetic loss tangent tanδ of more than 0.01 (or more than 0.03) and/or less than 0.08 (or less than 0.06). For example, the magnetic material 130 is an electrically conductive material (e.g. nickel iron NiFe alloy, a manganese Mn based material or a manganese Mn and zinc Zn based material) or an electrically insulating material. For example, the magnetic material 130 may be a paste having a permeability µ of more than 5 and/or less than 10 and a magnetic loss tangent tanδ of more than 0.02 and/or less than 0.07 at 100 MHz. For example, the magnetic material 130 may be a film or layer having a permeability µ of more than 9 and/or less than 12 and a magnetic loss tangent tanδ of more than 0.035 and/or less than 0.05 at 100 MHz. For example, the magnetic material 130 may be a mold compound having a permeability µ of more than 25 and/or less than 47 at 50 MHz. For example, the magnetic material 130 may be an electrically insulating material in direct contact with an electrically conductive material of the wiring structure 20. Alternatively, an electrically insulating material may be arranged between the magnetic material 130 and an electrically conductive material of the wiring structure 120, if the magnetic material is an electrically conductive material. For example, a distance between the magnetic material 130 and the electrically conductive material of the portion of the wiring structure 120 may be less than 1µm (or less than 500 nm, less than 200 nm, less than 100 nm or less than 50 nm).

The wiring structure 120 may comprise vias and wiring lines in different wiring layers. For example, the package structure comprises lateral wiring layers for lateral connections and vertical wiring layers for vertical connections. A lateral wiring layer (e.g. metal layer of a layer stack of the package structure) may be a layer for implementing lateral electrical connections (e.g. wiring lines) between vertical electrical connections (e.g. vias). A vertical wiring layer (e.g. via layer of a layer stack of the package structure) may be a layer for implementing vertical electrical connections (e.g. vias) between lateral electrical connections. For example, the portion of the wiring structure 120 may be at least a part of a via or at least a part of a wiring line. The wiring structure 120 or portions of the wiring structure 120 may comprise mainly (e.g. more than 50%) copper, aluminum, tungsten, gold or an alloy comprising mainly copper, aluminum, tungsten, gold and/or the wiring structure 120 and/or portions of the wiring structure 120 may be copper structures, aluminum structures, tungsten structures or gold structures.

The wiring structure 120 may be electrically connected to the semiconductor die 110 through a solder connection (e.g. a solder ball soldered to a contact pad of the semiconductor die and/or the package structure) or another connection between the package substrate 140 and a contact interface structure of the semiconductor die 110.

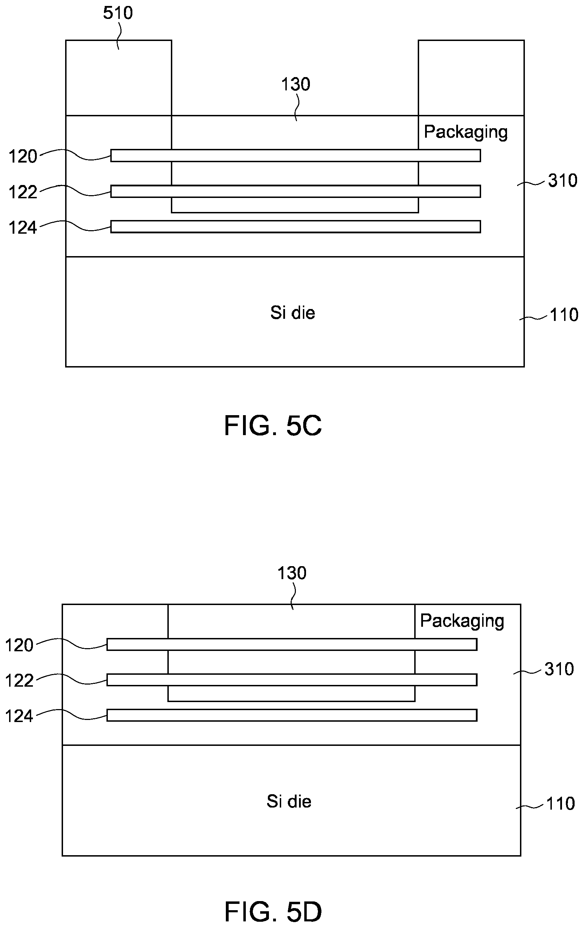

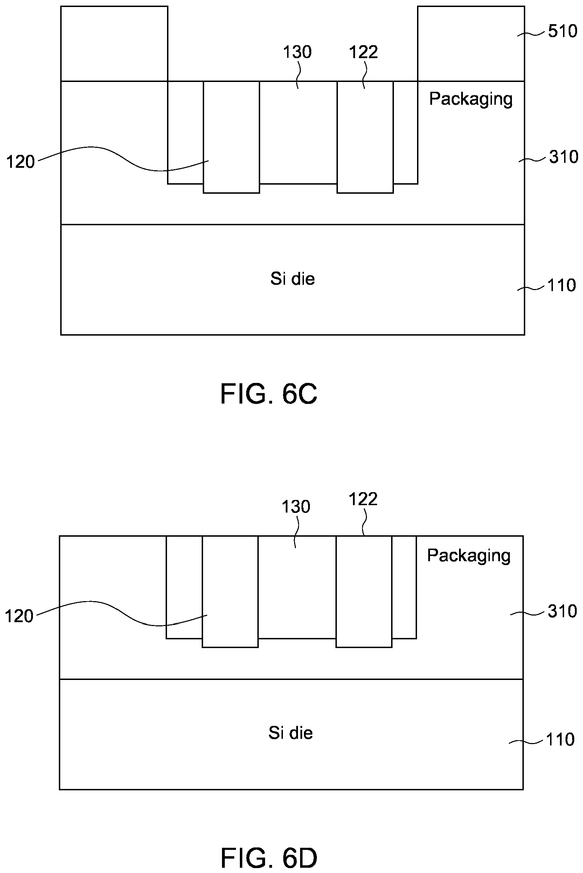

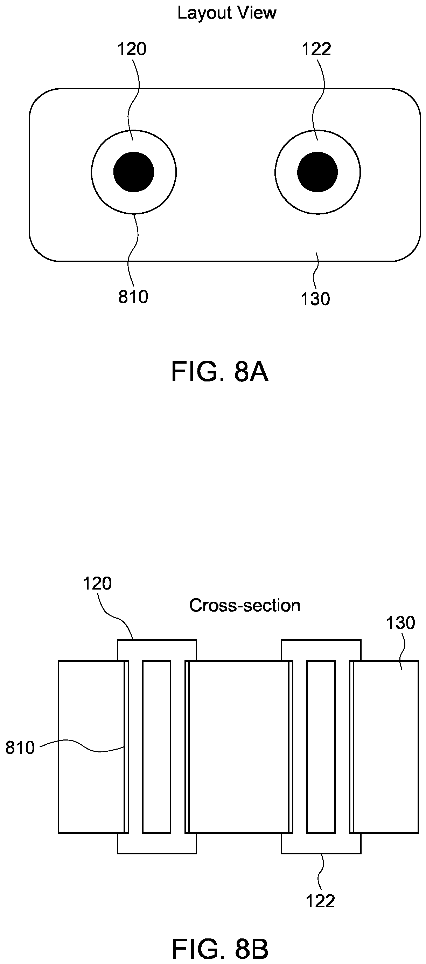

The semiconductor package 100 may comprise a second wiring structure. The magnetic material 130 may embed and/or encircle a portion of the second wiring structure. For example, the magnetic material 130 comprises at least one of an embedded portion which is embedded in the magnetic material, or an encircled portion which is encircled by the magnetic material. The magnetic material 130 may form a magnetic material structure, which embeds and/or encloses the embedded and/or encircled portion of the first wiring structure 120 and the embedded and/or encircled portion of the second wiring structure. In this way, it may be possible to suppress or reduce high-frequency interference on several wiring structures with a single magnetic material structure. The portion of the first wiring structure 120 and the portion of the second wiring structure may be located in the same wiring layer (e.g. Fig. 6d) or in adjacent wiring layers (e.g. Fig. 5d). For example, a distance between the portion of the wiring structure and the portion of the second wiring structure is less than 100 µm (or less than 50µm, less than 20µm or less than 10µm). For example, magnetic material of the magnetic material structure may be arranged between the embedded and/or encircled portion of the first wiring structure 120 and the embedded and/or encircled portion of the second wiring structure. By embedding and/or encircling portions of wiring structure, which are located close to each other, a common mode choke functionality may be obtained (e.g. Fig. 8a-10).

For example, the magnetic material 130 may form a magnetic ring. The magnetic material structure formed by the magnetic material 130 may be ring-shaped. The magnetic ring may encircle the portion of the wiring structure 120. In addition, an electrically conductive measurement structure may comprise at least one loop around the magnetic ring (e.g. 7a and 7b). In this way, it may be possible to implement a current sensor structure, which enables a measurement of a current conducted by the wiring structure. The electrically conductive measurement structure may be connected to a measurement circuit of the semiconductor die 110 or a measurement circuit of another component.

The semiconductor die 110 may comprise a plurality of contact interface structures (e.g. contact pads) for electrically connecting the semiconductor die 110 to the package substrate 140. A plurality of solder balls 112 (e.g. ball grid array BGA) may be arranged on the contact interface structures of the semiconductor die 110. The plurality of solder balls may be soldered to a plurality of contact interface structures (e.g. contact pads) of the package substrate 140. The semiconductor die 110 may comprise a semiconductor substrate and a wiring layer stack formed on the semiconductor substrate. The semiconductor substrate may comprise or may be composed of a single crystal of a material which may include, but is not limited to silicon, germanium, silicon-germanium, germanium-tin, silicon-germanium-tin, or a group III-V compound semiconductor material. The semiconductor substrate may be a bulk substrate or may be part of a semiconductor-on-insulator SOI substrate.

The semiconductor die 110 may be a processor die (e.g. a Central Processing Unit CPU die, a Graphics Processing Unit GPU die, a microcontroller die or a Digital Signal Processor DSP die), a memory die, a Micro-Electro-Mechanical System MEMS die, a transceiver die or any other semiconductor die.

The semiconductor package 100 may comprise further semiconductor dies. The semiconductor package 100 may comprise a plurality of contact interface structures (e.g. contact pads) for electrically connecting the semiconductor package 100 to an external component (e.g. a circuit board). The plurality of contact interface structures may be located on a surface of the package structure (e.g. the package substrate 140). A plurality of solder balls 142 (e.g. ball grid array BGA) may be arranged on the contact interface structures of the semiconductor package 100.

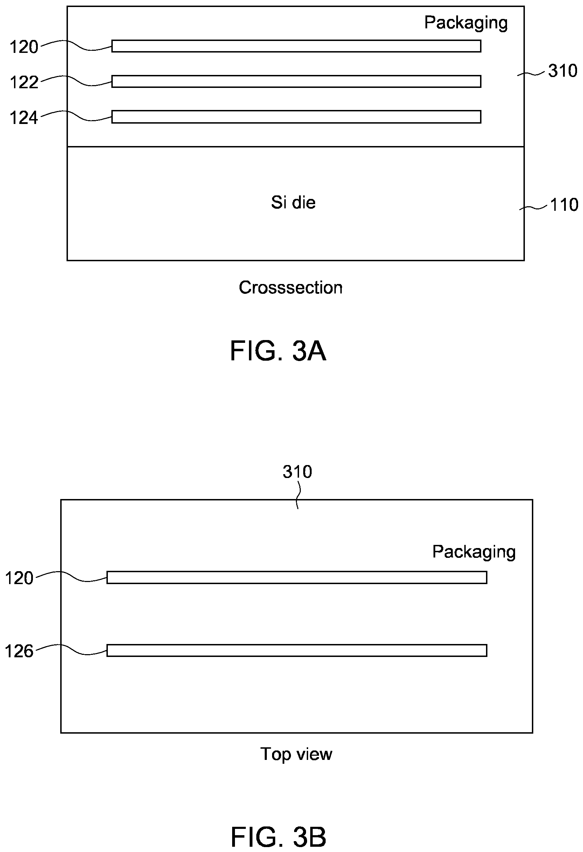

More details and aspects may be mentioned in connection with the examples described below (e.g. Fig. 3a-14).

Fig. 2 shows a schematic cross section of another semiconductor package. The semiconductor package 200 comprises a semiconductor die 110 and a wiring structure 120, which is electrically connected to the semiconductor die 110. Further, the semiconductor package 100 comprises a magnetic material 130. The magnetic material 130 embeds and/or encircles a portion of the wiring structure 120.

The semiconductor package 200 may be implemented similar to the semiconductor package described in connection with Fig. 1. However, the magnetic material 130 is at least partially embedded in at least one redistribution layer 250 instead of a package substrate. For example, a single redistribution layer or a multi-layer redistribution layer stack may be arranged on the semiconductor die 110.

The semiconductor package 200 may be a fan-out (or fan-in) package without a package substrate as shown in Fig. 2. For example, the semiconductor die may be at least partly embedded in mold material 240 and the least one redistribution layer 250 extend laterally along a front side of the semiconductor die 110 and a surface of the mold material 240. The mold material 240 may cover a backside of the semiconductor die 110as shown in fig. 2 or the backside might not be covered by the mold material 240.

Alternatively, the semiconductor package 200 may comprise a package substrate in addition to the at least one redistribution layer 250. The at least one redistribution layer 250 may be arranged between the semiconductor die 110 and a package substrate of the semiconductor package 200.

The wiring structure 120 may be electrically connected to the semiconductor die 110 through a via of a redistribution layer stack formed on a contact pad of the semiconductor die 110 or another connection between the at least one redistribution layer 250 and a contact interface structure of the semiconductor die 110.

The semiconductor package 200 may comprise a plurality of contact interface structures (e.g. contact pads) for electrically connecting the semiconductor package 200 to an external component (e.g. a circuit board). The plurality of contact interface structures may be located on a surface at least one redistribution layer 250 or on the redistribution layer stack comprising the at least one redistribution layer 250. A plurality of solder balls 252 (e.g. ball grid array BGA) may be arranged on the contact interface structures of the semiconductor package 200.

More details and aspects may be mentioned in connection with the examples described above (e.g. Fig. 1) or below (e.g. Fig. 3a-14).

Fig. 3a and 3b show a schematic cross section and top view of a semiconductor package during manufacturing. A redistribution layer stack 310 is formed on a semiconductor die 110 (e.g. a silicon Si die comprising a silicon substrate). Fig. 3a shows a wiring line of a first wiring structure 120, a wiring line of a second wiring structure 122 and a wiring line of a third wiring structure 124 located in different redistribution layers of the redistribution layer stack 310. Further, Fig. 3b shows a wiring line of a fourth wiring structure 126 located in the same redistribution layer of the redistribution layer stack 310 as the wiring line of the first wiring structure 120.

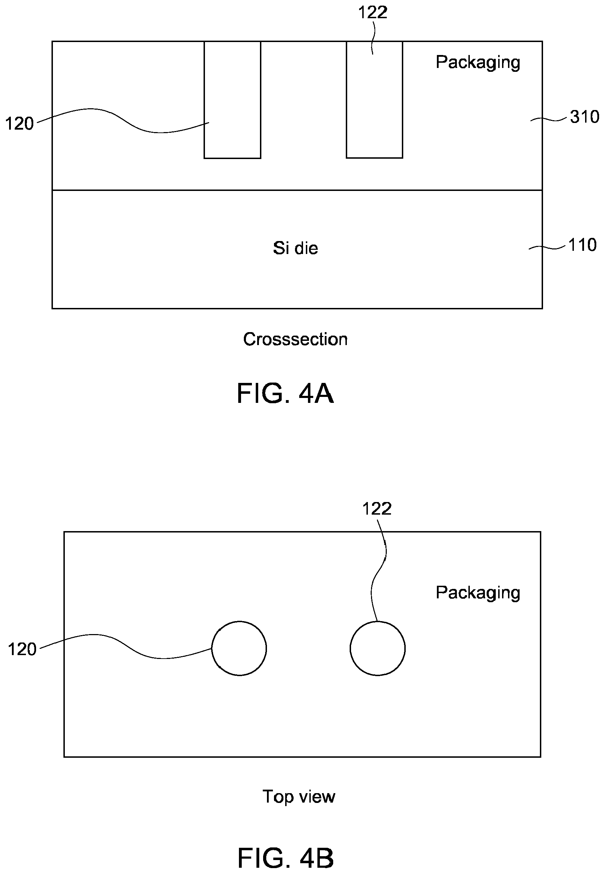

Fig. 4a and 4b show a schematic cross section and top view of another semiconductor package during manufacturing. A redistribution layer stack 310 is formed on a semiconductor die 110 (e.g. a silicon Si die comprising a silicon substrate). Fig. 4a and 4b show a via of a first wiring structure 120 and a via of a second wiring structure 122 located in the same redistribution layer of the redistribution layer stack 310.

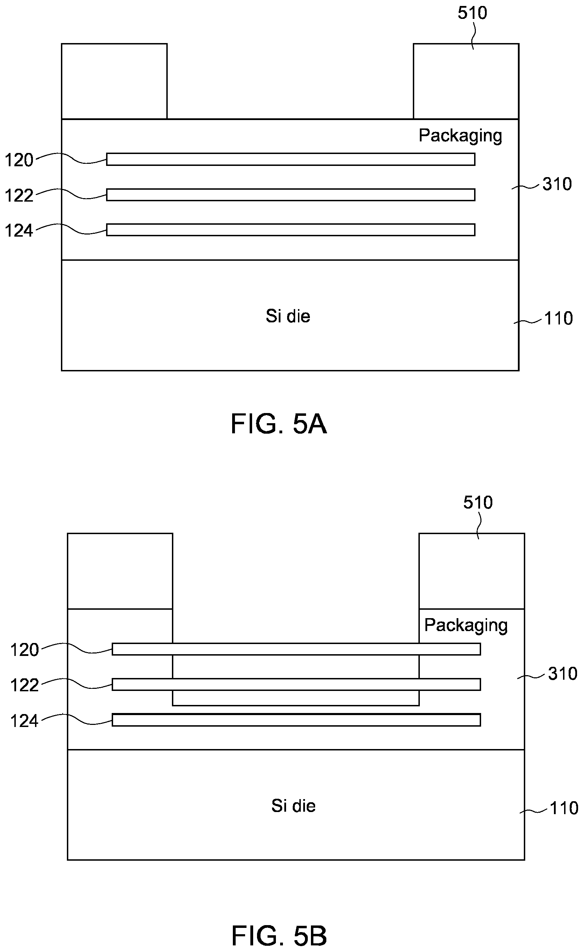

Fig. 5a-5d show schematic cross sections of a semiconductor package during manufacturing starting from the semiconductor package shown in Fig. 3a and 3b. A mask layer 510 (e.g. photo resist layer, silicon oxide layer or silicon nitride layer) is formed on top of the redistribution layer stack 310 as shown in Fig. 5a. One or more openings are formed (e.g. by lithography) in the mask layer 510 in order to define one or more areas for the magnetic material.

After forming the mask layer 510, a recess extending into the redistribution layer stack 310 is formed at the opening of the mask layer 510. For example, dielectric material of the redistribution layer stack 310 is etched to form the recess. For example, the dielectric material may be opened by an isotropic reactive ion etching (RIE) or a mix of isotropic and anisotropic reactive ion etching (RIE). The dielectric material of the redistribution layer stack 310 is etched to a depth so that at least a portion of a wiring structure, which should be embedded and/or enclosed by magnetic material is located in the recess. Fig. 5b shows an example having a portion of the wiring line of the first wiring structure 120 and a portion of the wiring line of the second wiring structure 122 located in the recess, but the wiring line of the third wiring structure 124 is still completely covered by the dielectric material of the redistribution layer stack 310.

After forming the recess, magnetic material 130 is deposited into the recess to embed and/or encircle a portion of at least one wiring structure. The magnetic material 130 can be disposed with or without using a mask layer (e.g. resist layer). If the magnetic material 130 is deposited without a resist, not needed magnetic material can be removed with CMP or a similar process. For example, Fig. 5c shows an example having a portion of the wiring line of the first wiring structure 120 and a portion of the wiring line of the second wiring structure 122 embedded and encircled by the magnetic material 130. The magnetic material 130 may be deposited with or without using lithography. If the magnetic material is an electrically conductive magnetic material, an isolation layer may be applied before the deposition of the magnetic material. For example, electrically insulating material may be formed in the recess so that the portion of the wiring line of the wiring structure is covered by an electrically insulating layer before depositing the magnetic material.

After the deposition of the magnetic material 130, the mask layer 510 is removed as shown in Fig. 5d. After the removal of the lithography (e.g. the mask layer), a planarization process may be performed (e.g. chemical mechanical polishing CMP). Then, the packaging process may continue with further dielectric deposition, lithography and/or RDL processes. In addition, pads and/or under bump metallization UBM may be formed before solder balls may be applied, solder may be deposited and/or a substrate and/or printed circuit board PCB process may be continued.

The process shown in Fig. 5a-5d may be used after the complete redistribution layer stack 310 is formed or after one or more specific layers of the redistribution layer stack 310 are formed. The process could be implemented between various redistribution layers, once or multiple times.

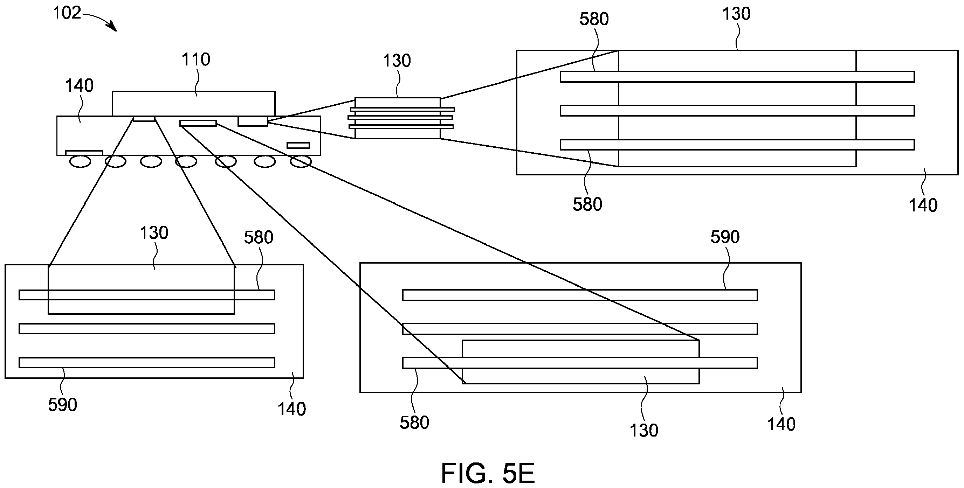

Fig. 5e shows a schematic cross section of a semiconductor package comprising magnetic material 130 implemented in a package substrate 140 of the semiconductor package 102. The semiconductor package 102 may be implemented similar to the semiconductor package described in connection with Fig. 1. The magnetic material may be formed in the built-up layers of the package substrate 140 similar as described in connection with Fig. 5a-5d for the implementation in the redistribution layer stack.

The package substrate 140 comprises several wiring structures 580 comprising portions embedded and/or encircled by magnetic material 130, while other wiring structures 590 of the package substrate 140 are not embedded and/or encircled by magnetic material 130. Several magnetic material structures comprising the magnetic material 130 are implemented at different positions in the package substrate 140 to embed and/or encircle different portions of different wiring structures.

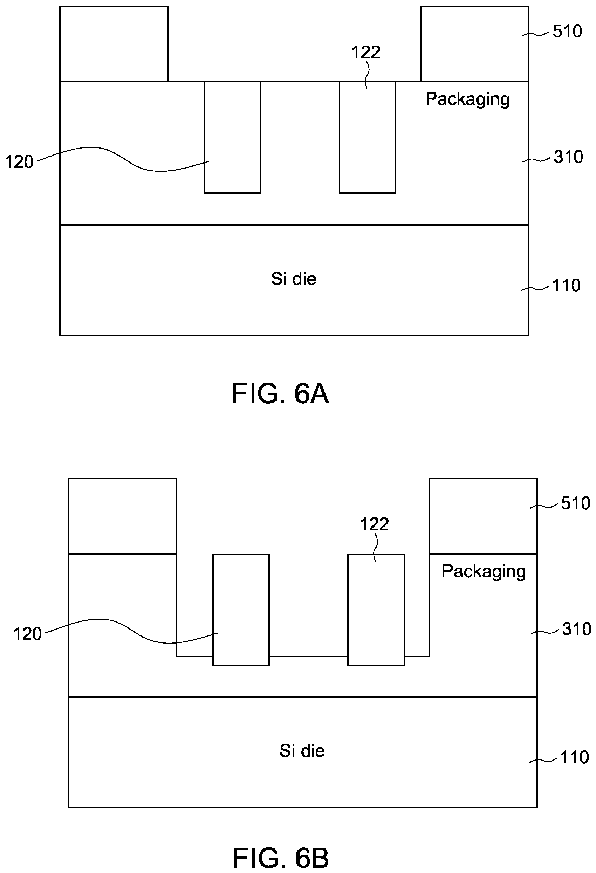

More details and aspects may be mentioned in connection with the examples described above (e.g. Fig. 1-5d) or below (e.g. Fig. 6a-14).

Fig. 6a-6d show schematic cross sections of another semiconductor package during manufacturing starting from the semiconductor package shown in Fig. 4a and 4b. A mask layer 510 (e.g. photo resist layer, silicon oxide layer or silicon nitride layer) is formed on top of the redistribution layer stack 310 as shown in Fig. 5a. One or more openings are formed (e.g. by lithography) in the mask layer 510 in order to define one or more areas for the magnetic material.

After forming the mask layer 510, a recess extending into the redistribution layer stack 310 is formed at the opening of the mask layer 510. For example, dielectric material of the redistribution layer stack 310 is etched to form the recess. For example, the dielectric material may be opened by an isotropic reactive ion etching (RIE) or a mix of isotropic and anisotropic reactive ion etching (RIE). The dielectric material of the redistribution layer stack 310 is etched to a depth so that at least a portion of a wiring structure, which should be embedded and/or enclosed by magnetic material is located in the recess. Fig. 6b shows an example having a portion of the via of the first wiring structure 120 and a portion of the via of the second wiring structure 122 located in the recess.

After forming the recess, magnetic material 130 is deposited into the recess to embed and/or encircle a portion of at least one wiring structure. For example, Fig. 6c shows an example having a portion of the via of the first wiring structure 120 and a portion of the via of the second wiring structure 122 embedded and encircled by the magnetic material 130. The magnetic material 130 may be deposited with or without using lithography. If the magnetic material is an electrically conductive magnetic material, an isolation layer may be applied before the deposition of the magnetic material. For example, electrically insulating material may be formed in the recess so that the portion of the via of the wiring structure is covered by an electrically insulating layer before depositing the magnetic material.

After the deposition of the magnetic material 130, the mask layer 510 is removed as shown in Fig. 6d. After the removal of the lithography (e.g. the mask layer), a planarization process may be performed (e.g. chemical mechanical polishing CMP). Then, the packaging process may continue with further dielectric deposition, lithography and/or RDL processes. In addition, pads and/or under bump metallization UBM may be formed before solder balls may be applied, solder may be deposited and/or a substrate and/or printed circuit board PCB process may be continued.

The process shown in Fig. 6a-6d may be used after the complete redistribution layer stack 310 is formed or after one or more specific layers of the redistribution layer stack 310 are formed. The process could be implemented between various redistribution layers, once or multiple times.

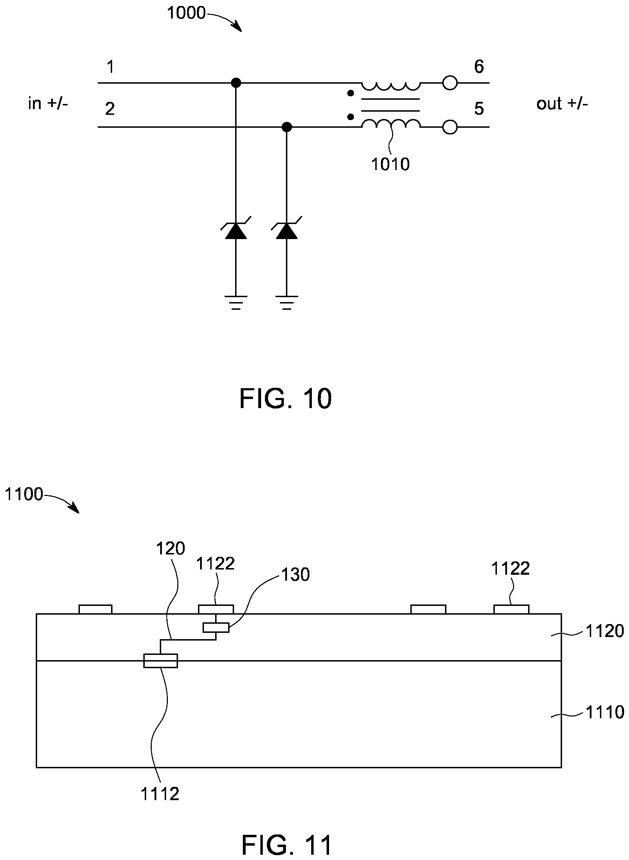

Fig. 3a-6d may show examples for manufacturing processes for integrating magnetic material for wiring lines or vias (e.g. in a fan-in and/or fan-out package). Similarly, the described manufacturing process may also be used to integrate magnetic material in a package substrate (e.g. the package substrate of the semiconductor package of Fig. 1) or in a wiring layer stack of a semiconductor die (e.g. Fig. 11).

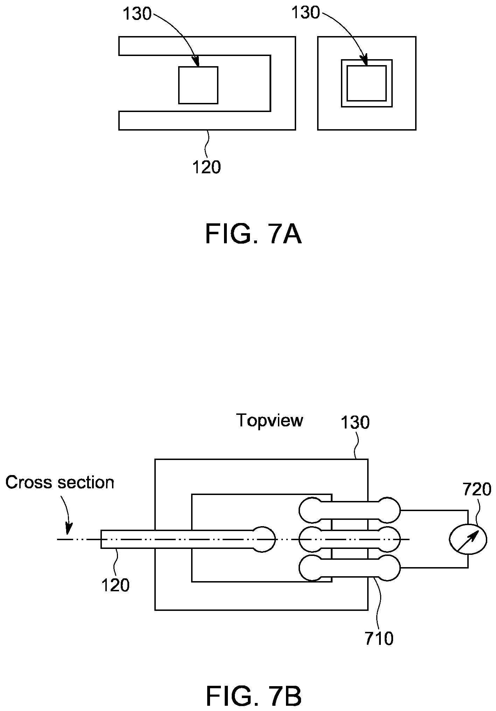

More details and aspects may be mentioned in connection with the examples described above (e.g. Fig. 1-2) or below (e.g. Fig. 7a-14).

Fig. 7a and 7b show a schematic cross section and top view of a current sending structure for a current sensor. A magnetic material structure comprising magnetic material 130 encircles a portion of a wiring structure 120. The magnetic material 130 forms a magnetic ring around the portion of the wiring structure 120. Further, an electrically conductive measurement structure 710 comprises at least one loop around the magnetic ring. In the example of Fig. 7b, the electrically conductive measurement structure 710 has three loops, but any other number of loops is also possible. The electrically conductive measurement structure may be connected to a measurement circuit 720. The measurement circuit 720 may be implemented on a semiconductor die of the semiconductor package comprising the current sending structure or may be implemented external to the semiconductor package comprising the current sending structure. For example, a current through the wiring structure 120 causes a current in the electrically conductive measurement structure 710 due to an inductive coupling via the magnetic ring, which can be measured by the measurement circuit 720.

More details and aspects may be mentioned in connection with the examples described above (e.g. Fig. 1-6d) or below (e.g. Fig. 8a-14).

Fig. 8a and 8b show a schematic cross section and top view of a common mode choke structure. For example, a common mode choke is an electrical filter that blocks high frequency noise common to two or more data or power lines while allowing the desired DC or low-frequency signal to pass. In common mode, the current in a group of lines travels in the same direction so the combined magnetic flux adds to create an opposing field to block the noise. Such a functionality may be implemented by embedding and/or encircling portions of two wiring structures by magnetic material.

For example, a portion (e.g. at least a part of a via or a wiring line) of a first wiring structure 120 and a portion (e.g. at least a part of a via or a wiring line) of a second wiring structure 122 are embedded and/or encircled by magnetic material 130 as shown in Fig. 8a and 8b. An electrically insulating material layer 810 may be arranged between the magnetic material 130 and the portion of the first wiring structure 120 and between the magnetic material 130 and the portion of the second wiring structure 122.

The first wiring structure may be a power supply wiring structure for providing a power supply voltage and the second wiring structure may be a reference voltage wiring structure for providing a reference voltage (e.g. ground). Alternatively, the first wiring structure and the second wiring structure may be differential lines for providing a differential signal.

Fig. 8a and 8b may show a structure for implementing a common mode choke to suppress electromagnetic interference and/or an integration into electrostatic discharge protection elements for IO circuitries.

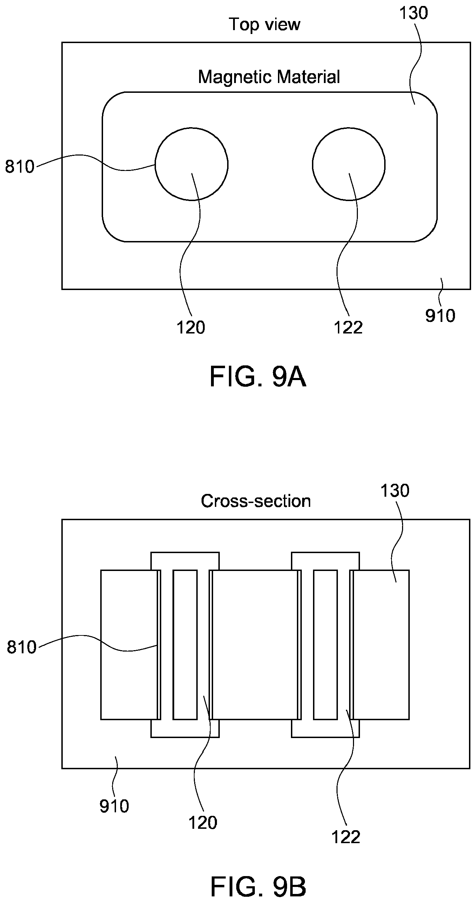

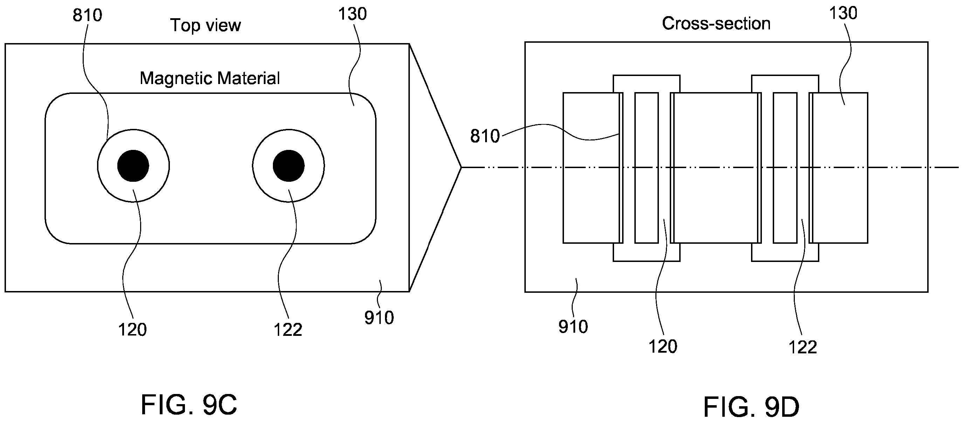

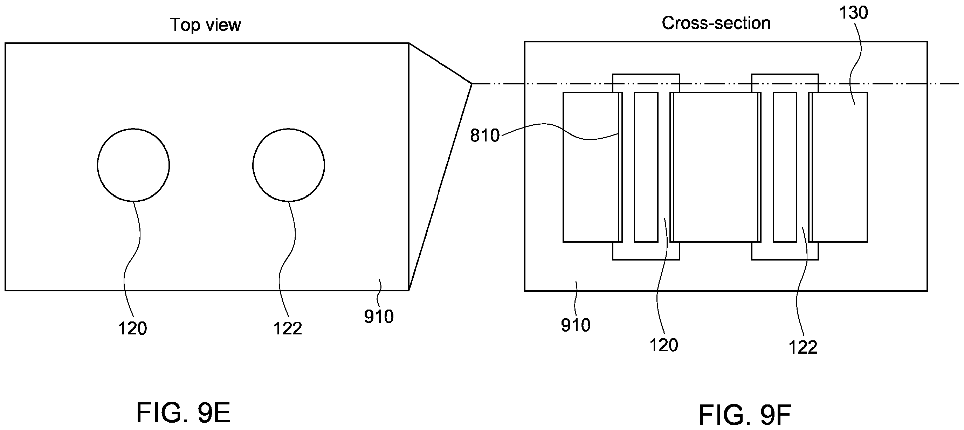

More details and aspects may be mentioned in connection with the examples described above (e.g. Fig. 1-7b) or below (e.g. Fig. 9a-14).

Fig. 9a and 9b show a schematic cross section and top view of a common mode choke structure embedded in dielectric material 910. For example, the common mode choke structure of Fig. 8a and 8b may be embedded in dielectric material 910 of a redistribution layer of a semiconductor package, a package substrate of a semiconductor package or a wiring layer stack of a semiconductor die. For example, Fig. 9a shows an example with a completely filled via and Fig. 9b shows an example with plated vias leaving a void in the middle of the via.

Fig. 9c-9f show schematic cross sections and top views of embedded and/or encircled plated vias. Fig. 9c shows a top view along a line in the middle of the vias and Fig. 9e shows a top view along the upper end of the vias.

More details and aspects may be mentioned in connection with the examples described above (e.g. Fig. 1-8b) or below (e.g. Fig. 10-14).

Fig. 10 shows a schematic illustration of an electrostatic discharge protection circuit 1000. The discharge protection circuit 1000 comprises a differential input with a first input 1 connected to a first pad of a semiconductor die and a second input 2 connected to a second pad of a semiconductor die. Further, the discharge protection circuit 1000 comprises a differential output with a first output 6 connected to circuitry of the semiconductor die and a second output 5 connected to circuitry of the semiconductor die. A common mode choke structure 1010 (e.g. as shown in Fig. 8a-8b) is located between the differential input and the differential output. Further, diodes are located between ground and nodes between the differential input and the common mode choke structure 1010.

Fig. 10 may show an example for integration of electrostatic discharge protection elements for IO circuitries.

More details and aspects may be mentioned in connection with the examples described above (e.g. Fig. 1-9b) or below (e.g. Fig. 11-14).

Fig. 11 shows a schematic cross section of a semiconductor die. The semiconductor die 1100 comprises a semiconductor substrate 1110 and a wiring layer stack 1120 arranged on the semiconductor substrate 1110. The wiring layer stack 1120 comprises at least a part of a wiring structure 120. The wiring structure 120 extends from a contact interface structure 1122 (e.g. contact pad) to the semiconductor substrate 1110. The wiring layer stack 1120 comprises magnetic material 130. The magnetic material 130 at least one of embeds or encircles a portion of the wiring structure 120.

By embedding or encircling portions of wiring structures by magnetic material, a strong inductive coupling can be obtained. Due to the strong inductive coupling, high frequency portions of electrical signals on the wiring structure may be efficiently filtered. For example, high-frequency interference may be efficiently suppressed or reduced. For example, the ESD protection of the semiconductor die may be improved.

The integration of the magnetic material 130 and/or the wiring structure 120 in the wiring layer stack 1120 of the semiconductor die 1100 may be implemented similar to the integration of the magnetic material 130 and/or the wiring structure 120 in the package substrate as described in connection with Fig. 1 or the redistribution layer stack as described in connection with one or more of Fig. 2 and Figs. 3a-6d.

The wiring layer stack 1120 may comprise lateral wiring layers for lateral wiring connections and vertical wiring layers for vertical wiring connections. A lateral wiring layer (e.g. metal layer) may be a layer for implementing lateral electrical connections (e.g. wiring lines) between vertical electrical connections (e.g. vias). A vertical wiring layer (e.g. via layer) may be a layer for implementing vertical electrical connections (e.g. vias) between lateral electrical connections. For example, the portion of the wiring structure 120 may be at least a part of a via or at least a part of a wiring line. The wiring structure 120 or portions of the wiring structure 120 may comprise mainly (e.g. more than 50%) copper, aluminum, tungsten, gold or an alloy comprising mainly copper, aluminum, tungsten, gold and/or the wiring structure 120 or portions of the wiring structure 120 may be copper structures, aluminum structures, tungsten structures or gold structures.

The semiconductor die 1100 may comprise a plurality of contact interface structures 1122 (e.g. contact pads) for electrically connecting the semiconductor die 1100 to a package substrate or a redistribution layer. A plurality of solder balls (e.g. ball grid array BGA) may be arranged on the contact interface structures of the semiconductor die 110 or a redistribution layer may be formed on the semiconductor die 1100. The semiconductor substrate may comprise or may be composed of a single crystal of a material which may include, but is not limited to, silicon, germanium, silicon-germanium, germanium-tin, silicon-germanium-tin, or a group III-V compound semiconductor material. The semiconductor substrate may be a bulk substrate or may be part of a semiconductor-on-insulator SOI substrate.

The semiconductor die 1100 may be a processor die (e.g. a Central Processing Unit CPU die, a Graphics Processing Unit GPU die, a microcontroller die or a Digital Signal Processor DSP die), a memory die, a Micro-Electro-Mechanical System MEMS die or any other semiconductor die.

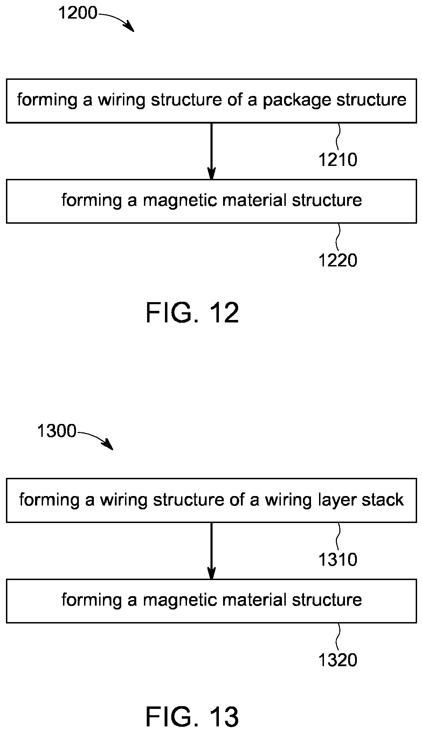

More details and aspects may be mentioned in connection with the examples described above (e.g. Fig. 1-10) or below (e.g. Fig. 12-14).

Fig. 12 shows a flow chart of a method of forming a semiconductor package. The method 1200 comprises forming 1210 a wiring structure of a package structure of the semiconductor package and forming 1220 a magnetic material structure of the semiconductor package so that a magnetic material of the magnetic material structure at least one of embeds or encircles a portion of the wiring structure.

The package structure may comprise or may be a package substrate or a redistribution layer.

The method 1200 may comprise attaching the package structure (e.g. a package substrate) to a semiconductor die so that the wiring structure is electrically connected to the semiconductor die. Alternatively, the method 1200 may comprise forming a redistribution layer on a semiconductor die. The redistribution layer may form at least a part of the package structure.

The method 1200 may comprise etching a recess into the package structure so that the portion of the wiring structure is located in the recess. Further, the method 1200 may comprise depositing the magnetic material in the recess to embed or encircle the portion of the wiring structure in the magnetic material.

In addition, the method 1200 may comprise depositing electrically insulating material in the recess so that the portion of the wiring structure is covered by an electrically insulating layer before depositing the magnetic material.

More details and aspects may be mentioned in connection with the examples described above (e.g. Fig. 1-11) or below (e.g. Fig. 13-14).

Fig. 13 shows a flow chart of a method of forming a semiconductor die. The method 1300 comprises forming 1310 a wiring structure of a wiring layer stack of the semiconductor die and forming 1320 a magnetic material structure of the semiconductor die so that a magnetic material of the magnetic material structure embeds or encircles a portion of the wiring structure.

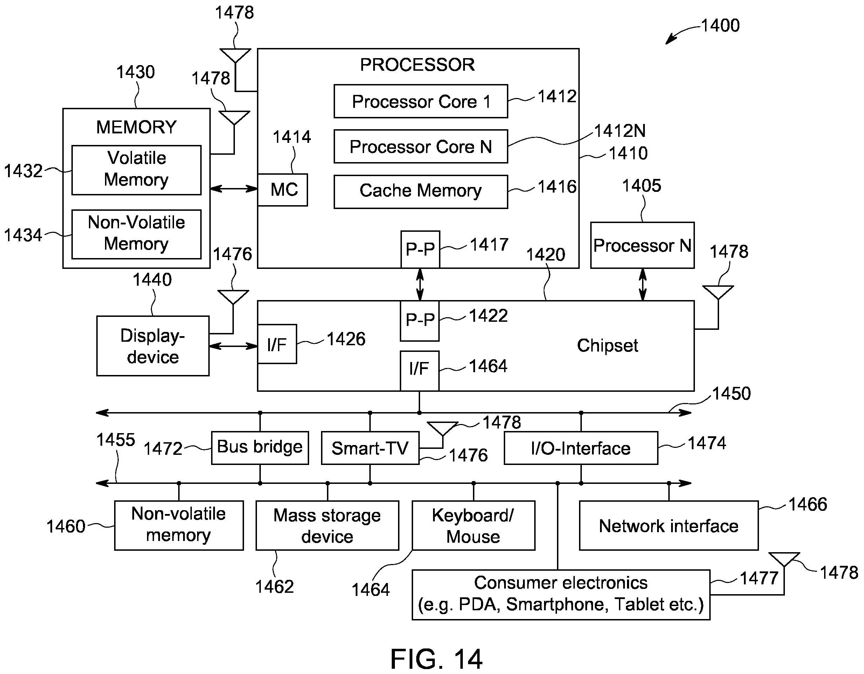

More details and aspects may be mentioned in connection with the examples described above (e.g. Fig. 1-12) or below (e.g. Fig. 14).

Some examples relate to an electronic device comprising a semiconductor package as described above or below or a semiconductor die as described above or below. Fig. 14 shows a block diagram of an electronic device. The electronic device may be a computing system 1400 includes (e.g. a desktop computer, a laptop, a mobile phone, a tablet, an internet appliance or a server).

In an example, the processor 1410 has one or more processing cores 1412 and 1412N, where 1412N represents the Nth processor core inside processor 1410 where N is a positive integer. In an example, the processing core 1412 includes, but is not limited to, pre-fetch logic to fetch instructions, decode logic to decode the instructions, execution logic to execute instructions and the like. In an example, the processor 1410 has a cache memory 1416 to cache at least one of instructions. The cache memory 1416 may be organized into a hierarchal structure including one or more levels of cache memory.

In an example, the processor 1410 includes a memory controller 1414, which is operable to perform functions that enable the processor 1410 to access and communicate with memory 1430 that includes at least one of a volatile memory 1432 and a non-volatile memory 1434. In an example, the processor 1410 is coupled with memory 1430 and chipset 1420. The processor 1410 may also be coupled to a wireless antenna 1478 to communicate with any device configured to at least one of transmit and receive wireless signals. In an example, the wireless antenna interface 1478 operates in accordance with, but is not limited to, the IEEE 802.11 standard and its related family, Home Plug AV (HPAV), Ultra Wide Band (UWB), Bluetooth, WiMax, or any form of wireless communication protocol.

In an example, the volatile memory 1432 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. The non-volatile memory 1434 includes, but is not limited to, flash memory, phase change memory (PCM), read-only memory (ROM), electrically erasable programmable read-only memory (EEPROM), or any other type of non-volatile memory device.

The memory 1430 stores information and instructions to be executed by the processor 1410. In an example, the memory 1430 may also store temporary variables or other intermediate information while the processor 1410 is executing instructions. In the illustrated example, the chipset 1420 connects with processor 1410 via Point-to-Point (PtP or P-P) interfaces 1417 and 1422. The chipset 1420 enables the processor 1410 to connect to other elements in the MAA apparatus examples in a system 1400. In an example, interfaces 1417 and 1422 operate in accordance with a PtP communication protocol such as the Intel^{®} QuickPath Interconnect (QPI) or the like. In other examples, a different interconnect may be used.

In an example, the chipset 1420 is operable to communicate with the processor 1410, 1405N, the display device 1440, and other devices 1472, 1476, 1474, 1460, 1462, 1464, 1466, 1477, etc. The chipset 1420 may also be coupled to a wireless antenna 1478 to communicate with any device configured to at least do one of transmit and receive wireless signals.

The chipset 1420 connects to the display device 1440 via the interface 1426. The display 1440 may be, for example, a liquid crystal display (LCD), a plasma display, cathode ray tube (CRT) display, or any other form of visual display device. Additionally, the chipset 1420 connects to one or more buses 1450 and 1455 that interconnect various elements 1474, 1460, 1462, 1464, and 1466. Buses 1450 and 1455 may be interconnected together via a bus bridge 1472. In an example, the chipset 1420 couples with a non-volatile memory 1460, a mass storage device(s) 1462, a keyboard/mouse 1464, and a network interface 1466 by way of at least one of the interface 1424 and 1474, the smart TV 1476, and the consumer electronics 1477, etc.

In an example, the mass storage device 1462 includes, but is not limited to, a solid state drive, a hard disk drive, a universal serial bus flash memory drive, or any other form of computer data storage medium. In one example, the network interface 1466 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one example, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in Figure 14 are depicted as separate blocks in a computing system 1400, the functions performed by some of these blocks may be integrated within a single semiconductor circuit or may be implemented using two or more separate integrated circuits. For example, although cache memory 1416 is depicted as a separate block within processor 1410, cache memory 1416 (or selected aspects of 1416) can be incorporated into the processor core 1412.

One or more components of the electronic device may comprise magnetic material integrated as mentioned in connection with the examples described above (e.g. Fig. 1-13) or below.

Some examples relate to an implementation of common mode chokes, current sensors and/or electrostatic discharge protection by employing magnetic materials in redistribution layers of packages.

High inductive coupling may be required. The same may be needed for electrically isolated current sensing. The readout and processing circuitry could be implemented on the chip IC.

By integrating magnetic material layers into the redistribution layers of packages the required physical properties may be offered within a packaged chip. By appropriate design of these layers and adjacent, surrounded, or surrounding metal interconnects the technical solution may also be realized on-chip. The dielectric of the package may be locally opened after RDL and the magnetic material may be directly applied to the die. This integration may be done, for example, on a fan-in or fan-t package, but also at e.g. a substrate or printed circuit board (PCB).

The implementation of the mentioned elements may be already possible together with chip-package co-design. No later additional design step may be needed. The space required by previously additional discrete elements may be saved. The current sensor could be placed closer to IO or supply pins and may allow monitoring of transient electrical stress and appropriately controlling the IC behavior (e.g. by resetting when needed).

External additional elements may be avoided to conform to required specification.

An example (e.g. example 1) relates to a semiconductor package comprising a semiconductor die; a wiring structure, which is electrically connected to the semiconductor die; and a magnetic material, wherein the magnetic material at least one of embeds or encircles a portion of the wiring structure.

Another example (e.g. example 2) relates to a previously described example (e.g. example 1) further comprising the magnetic material being at least partially embedded in a package structure, wherein the package structure is a package substrate or a redistribution layer.

Another example (e.g. example 3) relates to a previously described example (e.g. example 2) further comprising the wiring structure being at least partially embedded in the package structure.

Another example (e.g. example 4) relates to a previously described example (e.g. example 2) further comprising the package structure being a redistribution layer, wherein the redistribution layer is arranged between the semiconductor die and a package substrate of the semiconductor package.

Another example (e.g. example 5) relates to a previously described example (e.g. one of the examples 1-4) further comprising the portion of the wiring structure being at least a part of a via or a wiring line.

Another example (e.g. example 6) relates to a previously described example (e.g. one of the examples 1-5) further comprising the magnetic material being an electrically insulating material in direct contact with an electrically conductive material of the wiring structure.

Another example (e.g. example 7) relates to a previously described example (e.g. one of the examples 1-6) further comprising the magnetic material being an electrically conductive material, wherein an electrically insulating material is arranged between the magnetic material and an electrically conductive material of the wiring structure.

Another example (e.g. example 8) relates to a previously described example (e.g. one of the examples 1-7) further comprising the magnetic material comprising a nickel iron alloy, a manganese-based material or a manganese-and-zinc-based material.

Another example (e.g. example 9) relates to a previously described example (e.g. one of the examples 1-8) further comprising a second wiring structure, wherein the magnetic material at least one of embeds or encircles a portion of the second wiring structure.

Another example (e.g. example 10) relates to a previously described example (e.g. example 9) further comprising a distance between the portion of the wiring structure and the portion of the second wiring structure being less than 100 µm.

Another example (e.g. example 11) relates to a previously described example (e.g. one of the examples 9-10) further comprising the portion of the wiring structure and the portion of the second wiring structure being located in the same wiring layer or in adjacent wiring layers.

Another example (e.g. example 12) relates to a previously described example (e.g. one of the examples 1-11) further comprising the magnetic material forms a magnetic ring.

Another example (e.g. example 13) relates to a previously described example (e.g. example 12) further comprising an electrically conductive measurement structure comprising at least one loop around the magnetic ring.

Another example (e.g. example 14) relates to a previously described example (e.g. example 13) further comprising the electrically conductive measurement structure being connected to a measurement circuit of the semiconductor die.

An example (e.g. example 15) relates to a semiconductor die comprising a semiconductor substrate; and a wiring layer stack arranged on the semiconductor substrate, wherein the wiring layer stack comprises at least a part of a wiring structure, wherein the wiring structure extends from a contact interface structure to the semiconductor substrate, wherein the wiring layer stack comprises magnetic material, wherein the magnetic material at least one of embeds or encircles a portion of the wiring structure.

Another example (e.g. example 16) relates to a previously described example (e.g. example 15) further comprising the wiring structure being electrically connected to an electrostatic discharge protection structure of the semiconductor die.

Another example (e.g. example 17) relates to an electronic device comprising a semiconductor package according to a previously described example (e.g. one of the examples 1-14).

Another example (e.g. example 18) relates to an electronic device comprising a semiconductor die according to a previously described example (e.g. one of the examples 15-16).

An example (e.g. example 19) relates to a method of forming a semiconductor package, the method comprising forming a wiring structure of a package structure of the semiconductor package; and forming a magnetic material structure of the semiconductor package so that a magnetic material of the magnetic material structure at least one of embeds or encircles a portion of the wiring structure.

Another example (e.g. example 20) relates to a previously described example (e.g. example 19) further comprising attaching the package structure to a semiconductor die so that the wiring structure is electrically connected to the semiconductor die.

Another example (e.g. example 21) relates to a previously described example (e.g. example 19) further comprising the package structure comprising a redistribution layer formed on a semiconductor die.

Another example (e.g. example 22) relates to a previously described example (e.g. one of the examples 19-21) further comprising etching a recess into the package structure so that the portion of the wiring structure is located in the recess; and depositing the magnetic material in the recess to embed or encircle the portion of the wiring structure in the magnetic material.

Another example (e.g. example 23) relates to a previously described example (e.g. example 22) further comprising depositing electrically insulating material in the recess so that the portion of the wiring structure is covered by an electrically insulating layer before depositing the magnetic material.

An example (e.g. example 24) relates to a method of forming a semiconductor die, comprising forming a wiring structure of a wiring layer stack of the semiconductor die; and forming a magnetic material structure of the semiconductor die so that a magnetic material of the magnetic material structure embeds or encircles a portion of the wiring structure.

The aspects and features described in relation to a particular one of the previous examples may also be combined with one or more of the further examples to replace an identical or similar feature of that further example or to additionally introduce the features into the further example.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A semiconductor package, comprising:
a semiconductor die;
a wiring structure, which is electrically connected to the semiconductor die; and
a magnetic material, wherein the magnetic material at least one of embeds or encircles a portion of the wiring structure.

2. The semiconductor package of claim 1, wherein the magnetic material is at least partially embedded in a package structure, wherein the package structure is a package substrate or a redistribution layer.

3. The semiconductor package of claim 2, wherein the wiring structure is at least partially embedded in the package structure.

4. The semiconductor package of claim 2 or 3, wherein the package structure is a redistribution layer, wherein the redistribution layer is arranged between the semiconductor die and a package substrate of the semiconductor package.

5. The semiconductor package of any one of the preceding claims, wherein the portion of the wiring structure is at least a part of a via or a wiring line.

6. The semiconductor package of any one of the preceding claims, wherein the magnetic material is an electrically insulating material in direct contact with an electrically conductive material of the wiring structure.

7. The semiconductor package of any one of the preceding claims, wherein the magnetic material is an electrically conductive material, wherein an electrically insulating material is arranged between the magnetic material and an electrically conductive material of the wiring structure.

8. The semiconductor package of any one of the preceding claims, wherein the magnetic material comprises a nickel iron alloy, a manganese-based material or a manganese-and-zinc-based material.

9. The semiconductor package of any one of the preceding claims, further comprising a second wiring structure, wherein the magnetic material at least one of embeds or encircles a portion of the second wiring structure.

10. A semiconductor die, comprising:
a semiconductor substrate; and
a wiring layer stack arranged on the semiconductor substrate, wherein the wiring layer stack comprises at least a part of a wiring structure, wherein the wiring structure extends from a contact interface structure to the semiconductor substrate, wherein the wiring layer stack comprises magnetic material, wherein the magnetic material at least one of embeds or encircles a portion of the wiring structure.

11. The semiconductor die of claim 10, wherein the wiring structure is electrically connected to an electrostatic discharge protection structure of the semiconductor die.

12. An electronic device comprising a semiconductor package according to any one of claim 1-9.

13. An electronic device comprising a semiconductor die according to any one of claim 10-11.

14. A method of forming a semiconductor package, the method comprising:
forming a wiring structure of a package structure of the semiconductor package; and
forming a magnetic material structure of the semiconductor package so that a magnetic material of the magnetic material structure at least one of embeds or encircles a portion of the wiring structure.

15. A method of forming a semiconductor die, comprising:
forming a wiring structure of a wiring layer stack of the semiconductor die; and
forming a magnetic material structure of the semiconductor die so that a magnetic material of the magnetic material structure embeds or encircles a portion of the wiring structure.
